(19) Europäisches Patentamt / European Patent Office / Office européen des brevets

(11) **EP 3 503 406 B1**

(12) **FASCICULE DE BREVET EUROPEEN**

(45) Date de publication et mention
de la délivrance du brevet:
**18.02.2026 Bulletin 2026/08**

(21) Numéro de dépôt: **18215529.1**

(22) Date de dépôt: **21.12.2018**

(51) Classification Internationale des Brevets (IPC):
**H03M 1/10** *(2006.01)*    **H03M 1/12** *(2006.01)*

(52) Classification Coopérative des Brevets (CPC):
**H03M 1/1004; H03M 1/1033;** H03M 1/12

---

(54) **PROCÉDÉ DE CORRECTION DES DÉFAUTS INTRODUITS PAR UN SYSTÈME DE NUMÉRISATION ET DISPOSITIFS ASSOCIÉS**

KORREKTURVERFAHREN DER FEHLER, DIE DURCH EIN DIGITALISIERUNGSSYSTEM EINGEFÜHRT WURDEN, UND ENTSPRECHENDE VORRICHTUNGEN

METHOD FOR CORRECTING FAULTS INTRODUCED BY A DIGITISATION SYSTEM AND ASSOCIATED DEVICES

---

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2017 FR 1701361**

(43) Date de publication de la demande:
**26.06.2019 Bulletin 2019/26**

(73) Titulaire: **Thales**
**92400 Courbevoie (FR)**

(72) Inventeurs:
• **MINGER, Bryce**
**92622 GENNEVILLIERS CEDEX (FR)**
• **FUCHÉ, Loïc**
**49309 CHOLET (FR)**

(74) Mandataire: **Lavoix**
**2, place d'Estienne d'Orves**
**75441 Paris Cedex 09 (FR)**

(56) Documents cités:
**US-A1- 2005 219 089    US-A1- 2017 324 421**

• **SHAZAD SALEEM ET AL: "On Blind Identification of Gain and Timing Mismatches in Time-Interleaved Analog-to-Digital Converters", PROCEEDINGS OF 33RD INTERNATIONAL CONFERENCE ON TELECOMMUNICATIONS AND SIGNAL PROCESSING (TSP 2010), 1 January 2010 (2010-01-01), XP055071910, Retrieved from the Internet <URL:http://userver.ftw.at/~vogel/Papers/2010_vogelTSP.pdf> [retrieved on 20130718]**
• **SHAHZAD SALEEM: "Adaptive blind calibration of gain and timing mismatches in a time-interleaved ADC - A performance analysis", 2013 IEEE INTERNATIONAL INSTRUMENTATION AND MEASUREMENT TECHNOLOGY CONFERENCE (I2MTC), IEEE, 13 May 2012 (2012-05-13), pages 2672 - 2677, XP032451734, ISSN: 1091-5281, ISBN: 978-1-4673-4621-4, DOI: 10.1109/I2MTC.2012.6229704**
• **WANG YINAN ET AL: "Joint Blind Calibration for Mixed Mismatches in Two-Channel Time-Interleaved ADCs", IEEE TRANSACTIONS ON CIRCUITS AND SYSTEMS I: REGULAR PAPERS, IEEE, US, vol. 62, no. 6, 1 June 2015 (2015-06-01), pages 1508 - 1517, XP011582947, ISSN: 1549-8328, [retrieved on 20150525], DOI: 10.1109/TCSI.2015.2418835**

- **BEAUMONT-SMITH A ET AL: "A VLSI chip implementation of an A/D converter error table compensator", COMPUTER STANDARDS & INTERFACES, ELSEVIER SEQUOIA , LAUSANNE, CH, vol. 23, no. 2, 1 May 2001 (2001-05-01), pages 111 - 122, XP004232992, ISSN: 0920-5489, DOI: 10.1016/S0920-5489(01) 00064-2**

**Description**

La présente invention concerne un procédé de correction des défauts introduits par un système de numérisation. La présente invention se rapporte également à des dispositifs associés au procédé. La présente invention concerne ainsi un produit programme d'ordinateur, un support lisible d'informations, un correcteur, un système de numérisation, une chaîne d'acquisition numérique, une chaîne de réception et un ensemble associés.

Les chaînes de réception radiofréquences numérisées comportent des systèmes de numérisation générant des composantes fréquentielles parasites. Par exemple, les composantes parasites du système de numérisation sont introduites par un convertisseur analogique-numérique et/ou son étage d'entrée, par exemple constitué d'un amplificateur. Les composantes parasites correspondent à des défauts introduits par le système de numérisation. Ces défauts sont principalement des distorsions non-linéaires.

Il est souhaitable de réduire les composantes parasites générées pour améliorer la qualité des signaux obtenus en sortie des chaînes de réception.

Pour cela, il est utilisé des modèles mathématiques décrivant le comportement non-linéaire dynamique des convertisseurs de numérisation. Ces modèles mathématiques appartiennent généralement à la famille des modèles de Volterra (Volterra, Hammerstein, Wiener-Hammerstein, DDR pour déviation à dynamique réduite, etc.). De tels modèles mathématiques sont d'autant plus complexes qu'ils impliquent un nombre de coefficients élevé dû à de forts ordres de non-linéarités et de profondeurs de mémoire. En effet, dans les cas généraux, les défauts dépendent de la valeur du signal d'excitation du système de numérisation à plusieurs instants.

Ainsi, les algorithmes d'estimation des coefficients de modèle par minimisation de l'erreur de modélisation au sens des moindres carrés classiques de l'état de la technique impliquent de connaître la version numérique idéale du signal analogique d'entrée du système de numérisation, ce qui n'est pas possible en pratique. De plus, dans le cas d'une application temps-réel, la complexité des modèles mathématiques de l'état de la technique engendre d'importantes charges calculatoires pour estimer les coefficients du modèle considéré.

Il est aussi connu des techniques des documents suivants :

- un article de Shazad Saleem intitulé « On Blind Identification of Gain and Timing Mismatches in Time-Interleaved Analog-to-Digital Converters »,
- un article de Shazad Saleem intitulé « Active Blind Calibration of Gain and Timing Mismatches in Time-Interleaved Analog-to-Digital Converters - A Performance Analysis », et
- un article de Yinan Wang et al. intitulé « Joint Blind Calibration for Mixed Mismatches in Two-Channel Time-Interleaved ADCs »
- le document US 2017/0324421 A1,
- le document US 2005/0219089 A1, et
- un article de Beaumont-Smith intitulé « A VLSI chip implementation of an A/D converter error table compensator ».

Il existe donc un besoin pour un procédé de correction des défauts introduits par un système de numérisation qui soit de mise en œuvre simple.

La présente description décrit un procédé de correction des défauts introduits par un système de numérisation selon la revendication 1.

Suivant des modes de réalisation particuliers, le procédé de correction comprend une ou plusieurs des caractéristiques des revendications 2 à 5, prise(s) isolément ou suivant toutes les combinaisons techniquement possibles.

La présente description porte également sur un produit programme d'ordinateur selon la revendication 6.

La présente description se rapporte aussi à un support lisible d'informations selon la revendication 7.

La présente description concerne aussi un correcteur selon la revendication 8.

La présente description porte également sur un système de numérisation selon la revendication 9.

La présente description décrit aussi une chaîne d'acquisition numérique selon la revendication 10.

La présente description est également relative à une chaîne de réception selon la revendication 11.

La présente description concerne aussi un ensemble selon la revendication 12.

D'autres caractéristiques et avantages de l'invention apparaîtront à la lecture de la description qui suit de modes de réalisation de l'invention, la description étant donnée à titre d'exemple uniquement et en référence aux dessins qui sont :

- figure 1, une vue schématique d'un ensemble comportant une chaîne de réception,
- figure 2, une vue schématique de la chaîne de réception de la figure 1, et
- figure 3, un schéma-bloc des opérations effectuées lors de la mise en œuvre d'un exemple d'un procédé de correction des défauts,

- figure 4, un schéma-bloc d'une partie des opérations effectuées lors de la mise en œuvre d'un exemple d'un procédé de correction des défauts selon la figure 3,
- figure 5, un schéma-bloc d'une autre partie des opérations effectuées lors de la mise en œuvre d'un exemple d'un procédé de correction des défauts selon la figure 3, et
- figure 6, un schéma-bloc d'encore une autre partie des opérations effectuées lors de la mise en œuvre d'un exemple d'un procédé de correction des défauts selon la figure 3.

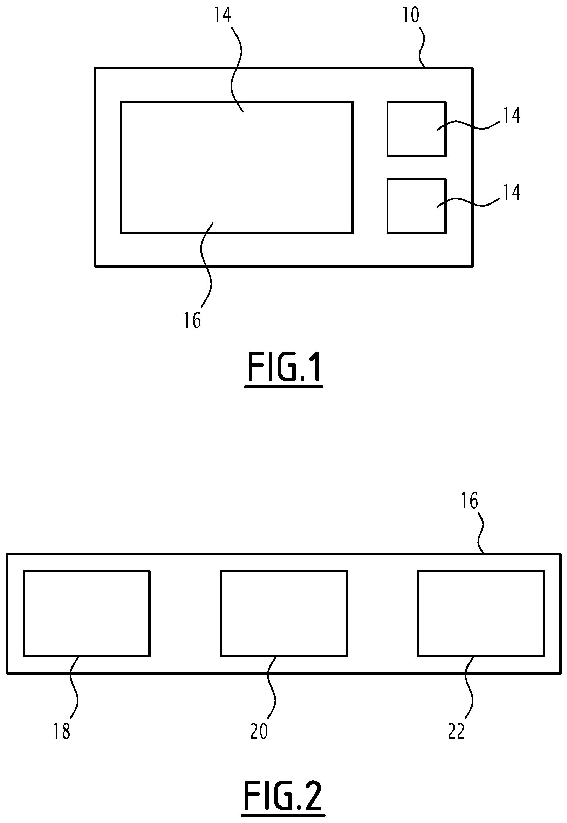

Un ensemble 10 est représenté schématiquement sur la figure 1.

L'ensemble 10 est, par exemple, un véhicule.

Selon un cas particulier, l'ensemble 10 est un aéronef.

L'ensemble 10 comporte des systèmes 14 fonctionnant en temps réel assurant le fonctionnement de l'ensemble 10.

Trois systèmes en temps réel 14 sont représentés sur la figure 1.

Pour la suite, il est supposé qu'un des systèmes en temps réel 14 est une chaîne de réception 16.

Un exemple de chaîne de réception 16 est représenté à la figure 2.

La chaîne de réception 16 comporte un étage de réception radiofréquence analogique 18, un système de numérisation 20 et un correcteur 22.

Par exemple, selon l'exemple proposé, l'étage de réception radiofréquence analogique 18 comporte une antenne propre à recevoir un signal radiofréquence et à le convertir en un signal électrique analogique. De manière connue en soi, l'étage de réception radiofréquence analogique 18 comprend aussi d'autres composants comme des filtres, des amplificateurs ou des mélangeurs.

L'ensemble constitué de l'étage de réception radiofréquence analogique 18, du système de numérisation 20 et du correcteur 22 forme une chaîne d'acquisition numérique.

Le système de numérisation 20 est propre à convertir un signal analogique en un signal numérique.

Par exemple, le système de numérisation 20 est un convertisseur analogique-numérique, ce qui est supposé dans la suite de la description.

Le convertisseur analogique-numérique 20 introduit des distorsions dans le signal analogique.

Cela implique que le convertisseur analogique-numérique 20 est un convertisseur analogique-numérique simple alternance, c'est-à-dire que le convertisseur analogique-numérique 20 n'est pas un convertisseur analogique-numérique entrelacé.

En particulier, les incompatibilités en temps ou en gain (gain and time mismatches dans la terminologique anglaise) ne sont pas des distorsions provenant du convertisseur analogique-numérique 20 mais des défauts provenant de la présence de l'entrelacement entre au moins deux convertisseurs analogique-numérique. Les défauts introduits par le convertisseur analogique-numérique 20 sont modélisables par un modèle théorique $\mathcal{M}$ liant un signal d'entrée du convertisseur analogique-numérique 20 et la dérivée temporelle du signal d'entrée à un signal de sortie du convertisseur analogique-numérique 20.

Le modèle théorique $\mathcal{M}$ est un modèle non-linéaire à mémoire et à temps discret.

Le modèle théorique $\mathcal{M}$ associe à chaque degré de non-linéarité un ensemble de plusieurs coefficients.

Dans un tel modèle $\mathcal{M}$, en notant $x[m]$ la version numérique idéale du signal analogique noté $x(t)$ appliqué en entrée du convertisseur analogique-numérique 20, il est obtenu l'équation 1 suivante :

$$y[m] = x[m] + \sum_{p=1}^{P} \sum_{n=0}^{p} h_p[n](x[m])^n \left(\frac{dx}{dt}[m]\right)^{p-n}$$

où :

- $y[m]$ le signal obtenu en sortie du convertisseur analogique-numérique 20,
- P est un entier désignant le degré maximal de non-linéarité,
- pour un degré de non-linéarité $p \in [\![1, P]\!]$ donnée, les $h_p[n]$, pour $p \in [\![0, P]\!]$, désigne l'ensemble des coefficients d'ordre $p$.

L'équation 1 peut également être écrite sous forme vectorielle comme suit :

$$y[k] = x[m] + \left[\underline{x}_m^{\mathcal{M}}\right]^T \underline{\theta}$$

où :

- $\underline{x}_m^{\mathcal{M}}$ est le vecteur de régression associé au modèle $\mathcal{M}$ et défini par :

$$\underline{x}_m^{\mathcal{M}} = \left[x[m], \frac{dx}{dt}[m], \left(\frac{dx}{dt}[m]\right)^2, x[m]\frac{dx}{dt}[m], x[m]^2, \dots, \left(\frac{dx}{dt}[m]\right)^P, \dots, x[m]^P\right]^T,$$

et

- $\underline{\theta}$ est le vecteur rassemblant les coefficients du modèle $\mathcal{M}$ et s'écrivant $\underline{\theta} =$

$$\left[h_1[0], h_1[1], h_2[0], h_2[1], h_2[2], \dots, h_P[0], \dots, h_P[P]\right]^T.$$

Le correcteur 22 est propre à corriger les défauts introduits par le convertisseur analogique-numérique 20.

Par « corriger », il est entendu une compensation acceptable au regard des performances souhaitées pour le convertisseur analogique-numérique 20.

Par exemple, une compensation acceptable est une compensation permettant de réduire le niveau des composantes parasites au plancher de bruit du convertisseur analogique-numérique 20 déterminé par le canal de la chaîne de réception 16 auquel le convertisseur analogique-numérique 20 appartient.

Pour cela, le correcteur 22 est adapté pour mettre en œuvre un procédé de correction des défauts.

Le correcteur 22 est, par exemple, un circuit logique programmable.

Un FPGA (acronyme de l'anglais « field-programmable gate array » traduit en français par « réseau de portes programmables in situ ») est un exemple de tel circuit logique programmable.

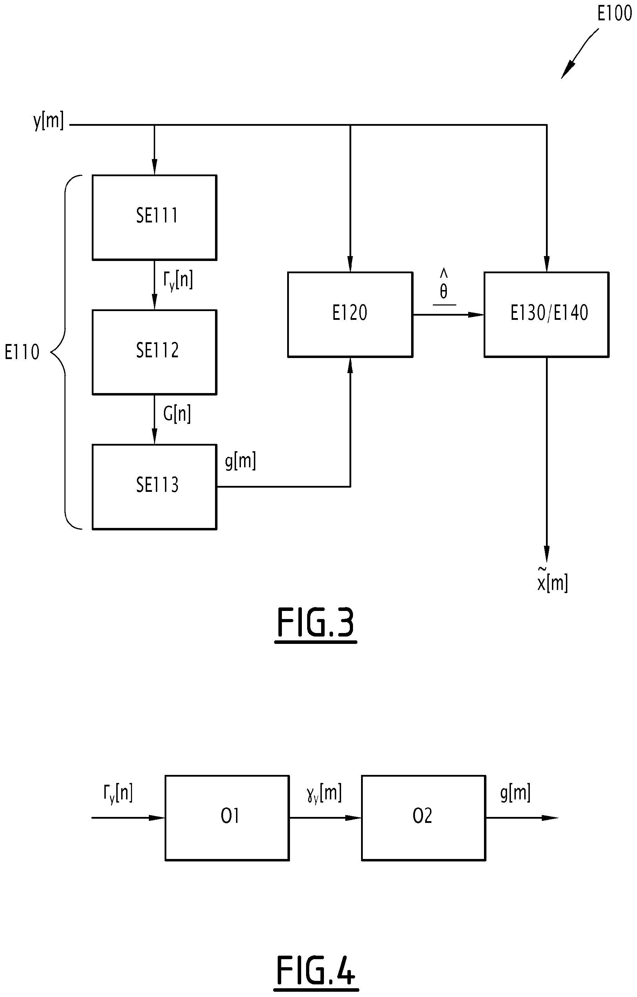

Le fonctionnement du correcteur 22 est maintenant décrit en référence à un exemple de mise en œuvre de procédé de correction des défauts introduits par le convertisseur analogique-numérique 20. Un tel exemple est illustré par les figures 3 à 6.

Le procédé de correction comporte une étape d'obtention E100, une étape de détermination d'un filtre E110, une étape de calcul E120, une étape d'application E130 et une étape de correction E140.

A l'étape d'obtention E100, il est obtenu le signal de sortie du convertisseur analogique-numérique 20.

Le signal de sortie correspond au signal distordu.

Le signal de sortie est noté pour la suite y[m].

Lors de l'étape de détermination d'un filtre, il est déterminé un filtre dont l'application au signal de sortie permet d'obtenir une approximation du signal d'entrée.

L'application du filtre peut être opérée par convolution dans le domaine temporel ou par produit dans le domaine fréquentiel.

L'étape d'obtention du filtre E110 comporte trois sous-étapes qui sont une sous-étape d'analyse spectrale SE111, une sous-étape de détection SE112 et une sous-étape de calcul SE113.

A la sous-étape d'analyse spectrale SE111, il est estimé la densité spectrale de puissance du signal distordu $y[m]$. La densité spectrale de puissance obtenue est notée $\Gamma_y[n]$.

La densité spectrale de puissance est estimée par mise en œuvre d'un algorithme d'analyse spectrale.

Par exemple, il est utilisé une transformée de Fourier rapide (aussi dénommée FFT pour « Fast Fourier Transform ») appliquée sur le signal distordu $y[m]$.

A la sous-étape de détection SE112, il est détecté les composantes en fréquence de la densité spectrale de puissance du signal distordu présentant des puissances supérieures à un seuil prédéterminé.

Le seuil prédéterminé dépend du point de fonctionnement du convertisseur analogique-numérique 20 ainsi que de ses performances de linéarités. De fait, le seuil prédéterminé est choisi pour ne détecter que les composantes non parasitées de plus forte puissance.

Il est alors déterminé un gabarit de filtre passe-bande $G[n]$ à partir des composantes détectées.

Selon un exemple simple, si une composante est détectée à une fréquence, alors le gabarit est égal à 1 à ladite fréquence, et en l'absence de composante détectée à une fréquence, le gabarit est égal à 0 à ladite fréquence.

A la sous-étape de calcul SE113, il est calculé la réponse impulsionnelle du filtre ayant pour gabarit $G[n]$. La réponse impulsionnelle est notée $g[m]$.

Un exemple de mise en œuvre de la sous-étape de calcul SE113 est décrit dans ce qui suit.

Dans cet exemple, comme visible sur la figure 4, la sous-étape de calcul SE113 comporte deux opérations O1 et O2.

Lors de la première opération O1, il est calculé la transformée de Fourier discrète inverse (aussi noté par l'acronyme TFDI) du gabarit *G*[*n*].

Par exemple, la transformée de Fourier discrète inverse est calculée par utilisation d'un algorithme de transformée de Fourier rapide inverse (aussi noté par l'acronyme TFRI ou son équivalent anglais IFFT pour « *inverse fast Fourier transform* »).

Lors de l'opération O2, la réponse impulsionnelle obtenue en sortie de la première opération O1 est tronquée à la longueur désirée.

En option, la réponse impulsionnelle est également pondérée par une fenêtre d'apodisation.

Ainsi, en sortie de l'étape d'obtention du filtre E110, il est obtenu la réponse impulsionnelle d'un filtre passe-bande adapté au signal distordu obtenu en sortie du convertisseur analogique-numérique 20.

Lors de l'étape de calcul E120, il est calculé les coefficients du modèle théorique $\mathcal{M}$ pour obtenir un modèle théorique calculé à partir d'une approximation du signal d'entrée d'une part et du signal de sortie du convertisseur analogique-numérique 20 d'autre part.

Par exemple, les coefficients du modèle $\mathcal{M}$ considéré sont déterminés par mise en œuvre d'un algorithme de minimisation de l'erreur de modélisation, notamment au sens des moindres carrés.

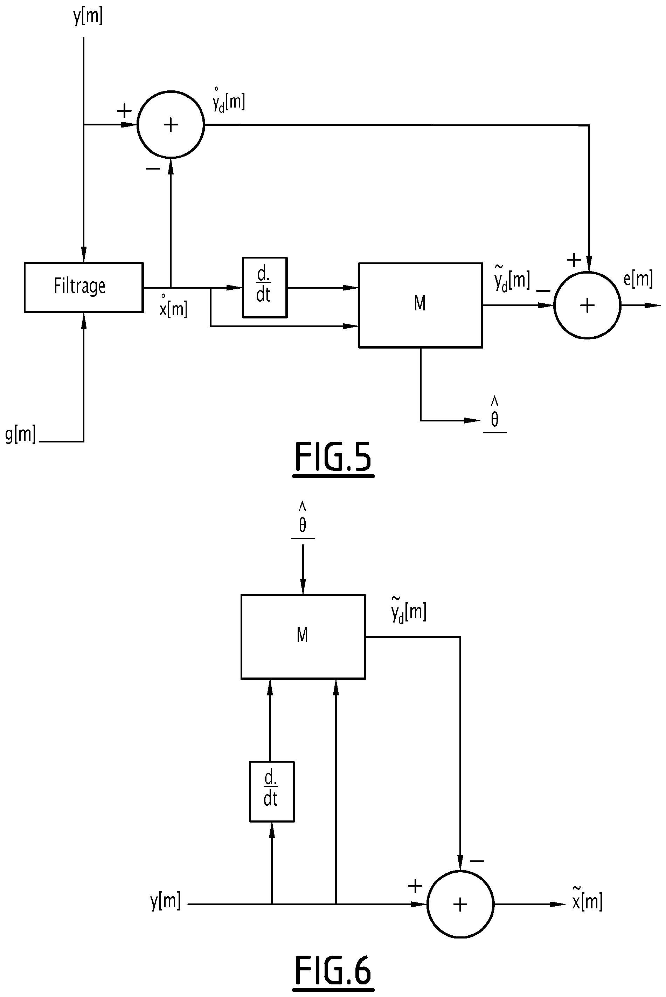

Plus explicitement, d'une part, le filtre de réponse impulsionnelle *h*[*m*] est utilisé pour construire une approximation grossière du signal numérique idéal *x*[*m*] du signal analogique d'excitation du système de numérisation 20 par filtrage du signal *y*[*m*] (la ou les composantes de plus fortes puissances sont conservées). D'autre part, l'inverse de ce filtre est utilisé (de façon optionnelle) pour supprimer les composantes de plus forte puissance du signal y[m]. Une alternative à ce deuxième filtrage consiste à opérer une soustraction entre le signal *y*[*m*] filtré par *h*[*n*] et le signal *y*[*m*] initial (voir figure 5). L'algorithme de minimisation de l'erreur de modélisation au sens des moindres carrés est alors opéré avec l'approximation grossière du signal numérique idéal *x*[*m*] et le signal résultant de la suppression des composantes de plus forte puissance du signal *y*[*m*].

De manière résumée, l'ensemble de ces coefficients est noté $\tilde{\underline{\theta}}$ sur la figure 3.

Formulé encore autrement, les coefficients $h_p$[*n*] du modèle $\mathcal{M}$ sont déterminés en recourant aux méthodes d'optimisation linéaire classique appliquées au problème du filtre de Wiener tel qu'il est posé dans la Figure 5. Notons *e*[*m*] l'erreur d'estimation définie telle que

$$e[m] = y[m] - \tilde{y}[m] = y_d[m] - \tilde{y}_d[m]$$

où :

- $y_d$[*m*] est défini comme *y*[*m*] - *x*[*m*], et
- les signaux notés avec un ~ sont des signaux calculés à l'aide du modèle $\mathcal{M}$.

L'identification des coefficients du modèle $\mathcal{M}$ consiste alors dans la minimisation de l'erreur d'estimation quadratique moyenne ou la somme quadratique de cette erreur. Par exemple, les coefficients sont alors obtenus par les solutions de Wiener-Hopf, des moindres carrés par bloc (BLS pour block least square), par l'algorithme des moindres carrés récursifs (RLS pour recursive least square), par l'algorithme des moindres carrés moyens simple (LMS pour least mean square) ou par l'algorithme des moindres carrés moyens normalisé (NLMS pour normalized least mean square).

Dans chacune des technique précédentes, l'estimation des coefficients $h_p$[*n*] implique de connaître les échantillons *x*[*m*] associés à l'excitation du système de numérisation 20. En l'occurrence, en remplacement de ces échantillons, il est utilisé une approximation grossière de *x*[*m*] obtenue par filtrage du signal distordu *y*[*m*] par la réponse impulsionnelle *g*[*m*] conçue précédemment. L'approximation grossière du signal est appelée *x*°[*m*].

Par ailleurs, l'étape de calcul comporte l'estimation de la dérivée temporelle du signal d'entrée.

Par exemple, cette estimation peut être effectuée par filtrage numérique de son approximation grossière *x*°[*m*].

Lors de l'étape E130, il est utilisé chaque coefficient du modèle $\mathcal{M}$ considéré ainsi que le modèle en question pour obtenir les défauts associés.

Il est ensuite mis en œuvre une étape de correction E140 en effectuant une soustraction au signal de sortie des défauts obtenus, pour obtenir un signal de sortie corrigé noté $\tilde{x}$[*m*].

Plus précisément, il est utilisé une partie du modèle $\mathcal{M}$ ainsi qu'un signal qui est le signal de sortie *y*[*m*], et non le signal idéal.

Le procédé décrit permet de déterminer un défaut spécifique sans connaître la version numérique idéale du signal analogique à obtenir en sortie du convertisseur analogique-numérique 20. Cela permet d'utiliser le procédé lorsqu'un ensemble 10 opère dans des conditions environnementales variables (température, composantes fréquentielles du signal d'excitation, puissance du signal d'excitation, ...). Le procédé est ainsi un procédé de correction sans calibrage.

Autrement formulé, le procédé propose la construction d'une approximation du signal $x[m]$ à partir du signal $y[m]$ distordu pour mettre en œuvre un algorithme d'estimation reposant sur un modèle non-linéaire à mémoire du convertisseur analogique-numérique 20 et qui ne suppose pas de connaître la version numérique idéale du signal analogique d'entrée $x[m]$.

La demanderesse a montré lors d'essai que le procédé d'estimation permet de déterminer sans calibrage et avec efficacité les défauts de numérisation introduits par le convertisseur analogique-numérique 20.

Le procédé s'applique à tout type de modèle théorique tel que les défauts introduits par le système de numérisation 20 sont modélisables par un modèle théorique liant un signal d'entrée du système de numérisation 20 et la dérivée temporelle du signal d'entrée à un signal de sortie du système de numérisation 20 et tel que le modèle théorique présente un degré maximal de non-linéarité et de façon optionnelle une profondeur de mémoire.

A titre d'exemple, le modèle est une variante du modèle décrit par l'équation 1 obtenue en exprimant le signal de sortie en fonction d'une combinaison linéaire de produits d'échantillons du signal d'entrée et de la dérivée temporelle du signal d'entrée à différents instants.

En outre, la complexité calculatoire de la mise en œuvre de ces modèles peut être réduite en considérant certains coefficients comme nuls, notamment les coefficients d'ordre pair ou d'ordre impair.

Plus généralement, le procédé s'applique à tout système ou sous-système d'acquisition numérique de signaux analogiques contenant un convertisseur analogique-numérique.

En particulier, le procédé est utilisable dans le cadre de récepteurs radiofréquences numérisés multicanaux, c'est-à-dire dont la bande instantanée est suffisamment large pour permettre le traitement simultané de plusieurs signaux de communications.

Il est également proposé des dispositifs permettant la mise en œuvre du procédé.

Par exemple, l'interaction d'un produit programme d'ordinateur avec un système permet de mettre en œuvre du procédé de correction.

Le système est un ordinateur.

Plus généralement, le système est un calculateur électronique propre à manipuler et/ou transformer des données représentées comme des quantités électroniques ou physiques dans des registres du système et/ou des mémoires en d'autres données similaires correspondant à des données physiques dans des mémoires, des registres ou d'autres types de dispositifs d'affichage, de transmission ou de mémorisation.

Le système comporte un processeur comprenant une unité de traitement de données, des mémoires et un lecteur de support d'informations. Le système comprend également un clavier et une unité d'affichage.

Le produit programme d'ordinateur comporte un support lisible d'informations.

Un support lisible d'informations est un support lisible par le système, usuellement par l'unité de traitement de données. Le support lisible d'informations est un médium adapté à mémoriser des instructions électroniques et capables d'être couplé à un bus d'un système informatique.

A titre d'exemple, le support lisible d'informations est une disquette ou disque souple (de la dénomination anglaise de « floppy disk »), un disque optique, un CD-ROM, un disque magnéto-optique, une mémoire ROM, une mémoire RAM, une mémoire EPROM, une mémoire EEPROM, une carte magnétique ou une carte optique.

Sur le support lisible d'informations est mémorisé un programme d'ordinateur comprenant des instructions de programme.

Le programme d'ordinateur est chargeable sur l'unité de traitement de données et est adapté pour entraîner la mise en œuvre du procédé de correction lorsque le programme d'ordinateur est mis en œuvre sur l'unité de traitement des données.

## Revendications

1. Procédé de correction des défauts introduits par un système de numérisation (20), le système de numérisation (20) étant un convertisseur analogique-numérique non-entrelacé, le système de numérisation (20) numérisant un signal d'entrée pour obtenir un signal de sortie, les défauts introduits par le système de numérisation (20) étant modélisables par un modèle théorique *(M)* liant un signal d'entrée du système de numérisation (20) et la dérivée temporelle du signal d'entrée à un signal de sortie du système de numérisation (20), le modèle théorique *(M)* étant un modèle non-linéaire à mémoire et à temps discret, le modèle théorique *(M)* associant à chaque degré de non-linéarité un ensemble de plusieurs coefficients, le procédé comprenant au moins les étapes de:

   - obtention du signal de sortie du système de numérisation (20),

- calcul des coefficients du modèle théorique *(M)* par minimisation de l'erreur entre le signal de sortie calculé par le modèle théorique *(M)* et le signal de sortie obtenu, pour obtenir un modèle théorique calculé,
- application du modèle théorique calculé au signal de sortie obtenu pour déterminer les distorsions introduites par le système de numérisation (20), et
- correction du signal de sortie pour obtenir un signal de sortie corrigé par soustraction des distorsions déterminées,

le procédé comportant, en outre, une étape de détermination d'un filtre, l'application du filtre sur le signal de sortie permettant d'obtenir une approximation du signal d'entrée, et l'étape de calcul se faisant par minimisation entre le signal de sortie calculé et le signal de sortie obtenu, le signal de sortie calculé s'obtenant en appliquant le modèle à l'approximation du signal d'entrée.

2. Procédé selon la revendication 1, dans lequel le procédé comporte l'étape de détermination d'un filtre comportant :

- l'estimation de la densité spectrale de puissance du signal distordu,
- la détection des composantes en fréquence de la densité spectrale de puissance du signal distordu présentant des puissances supérieures à un seuil prédéterminé,
- l'établissement d'un filtre passe-bande à partir des composantes détectées, et
- le calcul de la réponse impulsionnelle du filtre à partir du filtre passe-bande établi.

3. Procédé selon la revendication 1 ou 2, dans lequel l'étape de calcul des coefficients comporte l'estimation numérique de la dérivée temporelle du signal d'entrée.

4. Procédé selon l'une quelconque des revendications 1 à 3, dans lequel le modèle théorique *(M)* présente un degré maximal de non-linéarité et une profondeur de mémoire.

5. Procédé selon l'une quelconque des revendications 1 à 4, dans lequel le modèle théorique *(M)* est un modèle obtenu en exprimant le signal de sortie en fonction d'une combinaison linéaire de produits d'échantillons du signal d'entrée et de la dérivée temporelle du signal d'entrée à différents instants, le modèle étant éventuellement réduit en considérant des coefficients comme nuls.

6. Produit programme d'ordinateur comportant un support lisible d'informations, sur lequel est mémorisé un programme d'ordinateur comprenant des instructions de programme, le programme d'ordinateur étant chargeable sur une unité de traitement de données et adapté pour entraîner la mise en œuvre d'un procédé selon l'une quelconque des revendications 1 à 5 lorsque le programme d'ordinateur est mis en œuvre sur l'unité de traitement des données.

7. Support lisible d'informations mémorisant un programme d'ordinateur comprenant des instructions de programme, le programme d'ordinateur étant chargeable sur une unité de traitement de données et adapté pour entraîner la mise en œuvre d'un procédé selon l'une quelconque des revendications 1 à 5 lorsque le programme d'ordinateur est mis en œuvre sur l'unité de traitement des données.

8. Correcteur (22) adapté à mettre en œuvre un procédé de correction des défauts introduits par un système de numérisation (20), le système de numérisation (20) étant un convertisseur analogique-numérique non-entrelacé, le système de numérisation (20) numérisant un signal d'entrée pour obtenir un signal de sortie, les défauts introduits par le système de numérisation (20) étant modélisables par un modèle théorique ($\mathcal{M}$) liant un signal d'entrée du système de numérisation (20) et la dérivée temporelle du signal d'entrée à un signal de sortie du système de numérisation (20), le modèle théorique ($\mathcal{M}$) étant un modèle non-linéaire à mémoire et à temps discret, le modèle théorique ($\mathcal{M}$) associant à chaque degré de non-linéarité un ensemble de plusieurs coefficients, le procédé comprenant au moins les étapes de:

- obtention du signal de sortie du système de numérisation (20),
- calcul des coefficients du modèle théorique *(M)* par minimisation de l'erreur entre le signal de sortie calculé par le modèle théorique *(M)* et le signal de sortie obtenu, pour obtenir un modèle théorique calculé,
- application du modèle théorique calculé au signal de sortie obtenu pour déterminer les distorsions introduites par le système de numérisation (20), et
- correction du signal de sortie pour obtenir un signal de sortie corrigé par soustraction des distorsions déterminées,

le procédé comportant, en outre, une étape de détermination d'un filtre, l'application du filtre sur le signal de sortie permettant d'obtenir une approximation du signal d'entrée, et l'étape de calcul se faisant par minimisation entre le signal de sortie calculé et le signal de sortie obtenu, le signal de sortie calculé s'obtenant en appliquant le modèle à l'approximation du signal d'entrée.

9. Système de numérisation (20) comportant un correcteur (22) intégré, le correcteur (22) étant selon la revendication 8.

10. Chaîne d'acquisition numérique comportant un système de numérisation (20) et un correcteur (22) séparé du système de numérisation (20), le correcteur (22) étant selon la revendication 8.

11. Chaîne de réception (16) comportant un système de numérisation (20) selon la revendication 9 ou une chaîne d'acquisition numérique selon la revendication 10.

12. Ensemble (10), notamment aéronef, l'ensemble (10) comportant une chaîne de réception (16) selon la revendication 11.

**Patentansprüche**

1. Korrekturverfahren der Fehler, die von einem Digitalisierungssystem (20) eingeführt werden, wobei das Digitalisierungssystem (20) ein nicht verschachtelter Analog-Digital-Wandler ist, das Digitalisierungssystem (20) ein Eingangssignal digitalisiert, um ein Ausgangssignal zu erlangen, wobei die Fehler, die durch das Digitalisierungssystem (20) eingeführt werden, durch ein theoretisches Modell (M) modellierbar sind, das ein Eingangssignal des Digitalisierungssystems (20) und die zeitliche Ableitung des Eingangssignals mit einem Ausgangssignal des Digitalisierungssystems (20) verbindet, das theoretische Modell (M) ein zeitdiskretes, nichtlineares Speichermodell ist, das theoretische Modell (M) mit jedem Nichtlinearitätsgrad eine Anordnung von mehreren Koeffizienten assoziiert, das Verfahren umfassend mindestens die folgenden Schritte:

   - Erfassen des Ausgangssignals des Digitalisierungssystems (20),
   - Berechnen der Koeffizienten des theoretischen Modells (M) durch Minimieren des Fehlers zwischen dem durch das theoretische Modell (M) berechneten Ausgangssignal und dem erlangten Ausgangssignal, um ein berechnetes theoretisches Modell zu erlangen,
   - Anwenden des berechneten theoretischen Modells auf das erlangte Ausgangssignal, um die durch das Digitalisierungssystem (20) eingeführten Verzerrungen zu bestimmen, und
   - Korrigieren des Ausgangssignals, um ein korrigiertes Ausgangssignal zu erlangen, das durch Subtrahieren der bestimmten Verzerrungen korrigiert wird, das Verfahren ferner umfassend einen Schritt zum Bestimmen eines Filters, wobei

   die Anwendung des Filters auf das Ausgangssignal ermöglicht, eine Annäherung an das Eingangssignal zu erlangen, und wobei der Berechnungsschritt durch Minimieren zwischen dem berechneten Ausgabesignal und dem erlangten Ausgabesignal erfolgt, das berechnete Ausgangssignal durch Anwenden des Modells auf die Annäherung des Eingangssignals erlangt wird.

2. Verfahren nach Anspruch 1, wobei das Verfahren den Bestimmungsschritt umfasst, umfassend:

   - das Schätzen der spektralen Leistungsdichte des verzerrten Signals,
   - das Erfassen der Frequenzkomponenten der spektralen Leistungsdichte des verzerrten Signals, die Leistungen über einem vorbestimmten Schwellenwert aufweisen,
   - Wiederherstellen eines Bandpassfilters anhand der erfassten Komponenten, und
   - das Berechnen der Impulsantwort des festgelegten Bandpassfilters.

3. Verfahren nach Anspruch 1 oder 2, wobei der Berechnungsschritt der Koeffizienten das numerische Schätzen der zeitlichen Ableitung des Eingangssignals umfasst.

4. Verfahren nach einem der Ansprüche 1 bis 3, wobei das theoretische Modell (M) einen maximalen Nichtlinearitätsgrad und eine Speichertiefe aufweist.

5. Verfahren nach einem der Ansprüche 1 bis 4, wobei das theoretische Modell (M) ein Modell ist, das durch Ausdrücken des Ausgangssignals als eine Funktion einer linearen Kombination von Abtastprodukten des Eingangssignals und der zeitlichen Ableitung des Eingangssignals zu verschiedenen Zeitpunkten erlangt wird, wobei das Modell eventuell reduziert wird, indem Koeffizienten als ungültig betrachtet werden.

6.  Computerprogrammprodukt, umfassend einen lesbaren Informationsträger, auf dem ein Computerprogramm umfassend Programmanweisungen gespeichert ist, wobei das Computerprogramm auf eine Datenverarbeitungseinheit geladen werden kann und angepasst ist, um die Durchführung eines Verfahrens nach einem der Ansprüche 1 bis 5 zu bewirken, wenn das Computerprogramm auf der Datenverarbeitungseinheit durchgeführt wird.

7.  Lesbarer Informationsträger, auf dem ein Computerprogramm umfassend Programmanweisungen gespeichert ist, wobei das Computerprogramm auf eine Datenverarbeitungseinheit geladen werden kann und angepasst ist, um die Durchführung eines Verfahrens nach einem der Ansprüche 1 bis 5 zu bewirken, wenn das Computerprogramm auf der Datenverarbeitungseinheit durchgeführt wird.

8.  Korrektor (22), der angepasst ist, um ein Korrekturverfahren von Fehlern durchzuführen, die von einem Digitalisierungssystem (20) eingeführt werden, wobei das Digitalisierungssystem (20) ein nicht verschachtelter Analog-Digital-Wandler ist, das Digitalisierungssystem (20) ein Eingangssignal digitalisiert, um ein Ausgangssignal zu erlangen, wobei die Fehler, die durch das Digitalisierungssystem (20) eingeführt werden, durch ein theoretisches Modell (M) modellierbar sind, das ein Eingangssignal des Digitalisierungssystems (20) und die zeitliche Ableitung des Eingangssignals mit einem Ausgangssignal des Digitalisierungssystems (20) verbindet, das theoretische Modell (M) ein zeitdiskretes, nichtlineares Speichermodell ist, das theoretische Modell (M) mit jedem Nichtlinearitätsgrad eine Anordnung von mehreren Koeffizienten assoziiert, das Verfahren umfassend mindestens die folgenden Schritte:

    - Erfassen des Ausgangssignals des Digitalisierungssystems (20),
    - Berechnen der Koeffizienten des theoretischen Modells (M) durch Minimieren des Fehlers zwischen dem durch das theoretische Modell (M) berechneten Ausgangssignal und dem erlangten Ausgangssignal, um ein berechnetes theoretisches Modell zu erlangen,
    - Anwenden des berechneten theoretischen Modells auf das erlangte Ausgangssignal, um die durch das Digitalisierungssystem (20) eingeführten Verzerrungen zu bestimmen, und
    - Korrigieren des Ausgangssignals, um ein korrigiertes Ausgangssignal zu erlangen, das durch Subtrahieren der bestimmten Verzerrungen korrigiert wird, das Verfahren ferner umfassend einen Schritt zum Bestimmen eines Filters, wobei

    die Anwendung des Filters auf das Ausgangssignal ermöglicht, eine Annäherung an das Eingangssignal zu erlangen, und wobei der Berechnungsschritt durch Minimieren zwischen dem berechneten Ausgabesignal und dem erlangten Ausgabesignal erfolgt, das berechnete Ausgangssignal durch Anwenden des Modells auf die Annäherung des Eingangssignals erlangt wird.

9.  Digitalisierungssystem (20), umfassend einen integrierten Korrektor (22), wobei der Korrektor (22) nach Anspruch 8 ist.

10. Digitale Bilderfassungskette, umfassend ein Digitalisierungssystem (20) und einen Korrektor (22), der von dem Digitalisierungssystem (20) getrennt ist, wobei der Korrektor (22) nach Anspruch 8 ist.

11. Empfangskette (16), umfassend ein Digitalisierungssystem (20) nach Anspruch 9 oder eine digitale Erfassungskette nach Anspruch 10.

12. Anordnung (10), insbesondere Luftfahrzeug, die Anordnung (10) umfassend eine Empfangskette (16) nach Anspruch 11.


**Claims**

1.  A method for correcting defects introduced by a digitalization system (20), the digitalization system (20) being a non-interleaved analog-digital converter, the digitalization system (20) digitizing an input signal to obtain an output signal, the defects introduced by the digitalization system (20) being able to be modeled by a theoretical model ($\mathcal{M}$) linking an input signal of the digitalization system (20) and the temporal drift of the input signal to an output signal of the digitalization system (20), the theoretical model ($\mathcal{M}$)) being a nonlinear model with memory and discrete time, the theoretical model ($\mathcal{M}$) associating, with each degree of nonlinearity, a set of several coefficients, the method comprising at least the steps of:

- obtaining the output signal of the digitalization system (20),

- calculating coefficients of the theoretical model ($\mathcal{M}$) by minimizing the error between the output signal calculated by the theoretical model ($\mathcal{M}$) and the obtained output signal, to obtain a calculated theoretical model,
- applying the calculated theoretical model to the obtained output signal to determine the distortions introduced by the digitalization system (20), and
- correcting the output signal to obtain a corrected output signal by subtracting the determined distortions,

the method further including a step for determining a filter, applying the filter with the output signal making it possible to obtain an approximation of the input signal, and the step of calculating being carried out by a minimization between the calculated output signal and the obtained output signal, the calculated output signal being obtained by applying the model to the approximation of the input signal.

2. The method according to claim 1, wherein the method includes the step of determining a filter including:

- estimating the spectral power density of the distorted signal,
- detecting the frequency components of the spectral power density of the distorted signal having powers above a predetermined threshold,
- establishing a bandpass filter from the detected components, and
- calculating the impulse response of the filter from the established bandpass filter.

3. The method according to claim 1 or 2, wherein the calculating step includes the digital estimate of the temporal drift of the input signal.

4. The method according to any one of claims 1 to 3, wherein the theoretical model ($\mathcal{M}$) has a maximum degree of nonlinearity and a depth of memory.

5. The method according to any one of claims 1 to 4, wherein the theoretical model ($\mathcal{M}$) is a model obtained by expressing the output signal as a function of a linear combination of products of samples of the input signal and the temporal drift of the input signal at different moments, the model optionally being reduced by considering the coefficients to be nil.

6. A computer program product including a readable information medium, on which a computer program is stored comprising program instructions, the computer program being able to be loaded on a data processing unit and suitable for driving the implementation of a method according to any one of claims 1 to 5 when the computer program is implemented on the data processing unit.

7. A readable computer medium storing a computer program comprising program instructions, the computer program being able to be loaded on a data processing unit and suitable for driving the implementation of a method according to any one of claims 1 to 5 when the computer program is implemented on the data processing unit.

8. A corrector (22) suitable for carrying out a method for correcting defects introduced by the digitalization system (20), the digitalization system (20) being a non-interleaved analog-digital converter, the digitalization system (20) digitizing an input signal to obtain an output signal, the defects introduced by the digitalization system (20) being able to be modeled by a theoretical model ($\mathcal{M}$) linking an input signal of the digitalization system (20) and the temporal drift of the input signal to an output signal of the digitalization system (20), the theoretical model ($\mathcal{M}$) being a nonlinear model with memory and discrete time, the theoretical model ($\mathcal{M}$) associating, with each degree of nonlinearity, a set of several coefficients, the method comprising at least the steps of:

- obtaining the output signal of the digitalization system (20),

- calculating coefficients of the theoretical model ($\mathcal{M}$) by minimizing the error between the output signal calculated by the theoretical model ($\mathcal{M}$) and the obtained output signal, to obtain a calculated theoretical model,
- applying the calculated theoretical model to the obtained output signal to determine the distortions introduced by the digitalization system (20), and
- correcting the output signal to obtain a corrected output signal by subtracting the determined distortions;

the method further including a step for determining a filter, applying the filter with the output signal making it possible to obtain an approximation of the input signal, and the step of calculating being carried out by a minimization between the calculated output signal and the obtained output signal, the calculated output signal being obtained by applying the model to the approximation of the input signal.

9. A digitalization system (20) comprising an integrated corrector (22), the corrector (22) being according to claim 8.

10. A digital acquisition chain comprising a digitalization system (20) and a corrector (22) separated from the digitalization system (20), the corrector (22) being according to claim 8.

11. A reception chain (16) including a digitalization system (20) according to claim 9 or a digital acquisition chain according to claim 10.

12. An assembly (10), in particular an aircraft, the assembly (10) including a reception chain (16) according to claim 11.

14      10

14

14

16

## FIG.1

16

18      20      22

## FIG.2

E100

y[m]

```
      ┌──────────┐
      │          │
      │  SE111   │
      │          │
      └────┬─────┘
           │ Γ_y[n]
      ┌────▼─────┐
E110  │          │
      │  SE112   │
      │          │
      └────┬─────┘
           │ G[n]
      ┌────▼─────┐
      │          │ g[m]
      │  SE113   │
      │          │
      └──────────┘
```

```
┌──────────┐         ┌──────────┐
│          │   θ̂     │          │
│   E120   │────────▶│ E130/E140│
│          │         │          │
└──────────┘         └──────────┘
```

x̃[m]

## FIG.3

```
         ┌────────┐           ┌────────┐
 Γ_y[n]  │        │  γ_y[m]   │        │  g[m]
────────▶│   O1   │──────────▶│   O2   │────────▶
         │        │           │        │
         └────────┘           └────────┘
```

## FIG.4

FIG.5

FIG.6

**EP 3 503 406 B1**

## RÉFÉRENCES CITÉES DANS LA DESCRIPTION

**Documents brevets cités dans la description**

- US 20170324421 A1
- US 20050219089 A1